(19) Europäisches Patentamt

European Patent Office

Office européen des brevets

(11) **EP 1 178 605 A1**

(12) **EUROPÄISCHE PATENTANMELDUNG**

(43) Veröffentlichungstag:
06.02.2002  Patentblatt 2002/06

(51) Int Cl.$^7$: **H03K 7/08**

(21) Anmeldenummer: 00810643.7

(22) Anmeldetag: **19.07.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(71) Anmelder: **ABB RESEARCH LTD.**
**8050 Zürich (CH)**

(72) Erfinder: **Sabbatini, Bruno**
**5430 Wettingen (CH)**

(74) Vertreter: **ABB Patent Attorneys**
**c/o ABB Business Services Ltd, Intellectual Property (SLE-I), Haselstrasse 16/699**
**5401 Baden (CH)**

(54) **Verfahren und Vorrichtung zur Pulsbreitenmodulation**

(57)  Zur Erzeugung von Pulsen in einem Pulsbreitenmodulations-Verfahren wird ein Pulsgenerator (4) verwendet, der Pulse der Längen 0, 1, ... $n$ - 1 erzeugen kann. Ferner ist eine Steuerung (3) vorgesehen, die den Pulsgenerator aufgrund einer gewünschten Pulslänge r mit $0 \leq r \leq n$ - 1 zur Erzeugung von Pulsen verschiedener Längen $t(1)$, $t(2)$, ... $t(k)$ anregt, wobei der Mittelwert der Längen $t(i)$ der gewünschten Pulslänge r entspricht. Auf diese Weise lässt sich die Auflösung vergrössern, ohne dass die Granularität des Pulsgenerators (4) feiner gewählt werden müsste.

Fig. 1

**Beschreibung**

Technisches Gebiet

Die Erfindung betrifft ein Verfahren und eine Vorrichtung zur Pulsbreitenmodulation gemäss Oberbegriff der unabhängigen Ansprüche.

Stand der Technik

Um gesteuerte DC Quellen (oder "langsam wechselnde" beliebige Quellen) zu erzeugen, kann die Pulsbreitenmodulation (PWM) eingesetzt werden, bei welcher in einem Pulsgenerator Pulse einer Spannung $U1$ erzeugt werden. Die Pulse besitzen normalerweise alle die gleiche mittlere Länge $t \cdot T$, wobei t eine Ganzzahl und $T$ die zeitliche Granularität des Pulsgenerators ist. Werden die Pulse durch einen Tiefpass geführt, so entsteht eine Gleichspannung $U$ mit dem Wert

$$U = \frac{t}{n\text{-}1}U1,$$

wobei $n$ - 1 der maximalen Pulslänge bzw. $n$ der Zahl unterschiedlicher möglicher Spannungswerte $U$ entspricht.

Um den Tiefpass möglichst einfach zu halten, sollte die Wiederholfrequenz der Pulse und somit die Granularität bzw. Zeitauflösung des Pulsgenerators möglichst gross sein, was bei digitaler Erzeugung der Pulse eine entsprechend hohe Taktrate bedingt. Derart hohe Taktraten sind jedoch z.B. im Hinblick auf den entsprechenden Stromverbrauch oftmals unerwünscht oder schlicht nicht mit vernünftigem Aufwand realisierbar.

Darstellung der Erfindung

Es stellt sich deshalb die Aufgabe, ein Verfahren bzw. eine Vorrichtung der eingangs genannten Art bereitzustellen, die bei gegebener Granularität möglichst gute Auflösung besitzen und dennoch Störungen in tiefen Frequenzbereichen vermeiden.

Diese Aufgabe wird vom Verfahren bzw. der Vorrichtung gemäss der unabhängigen Ansprüche erfüllt.

Gemäss dem erfindungsgemässen System können also Pulse einer mittleren Länge $r \cdot T$ erzeugt werden, wobei $T$ die Granularität (zeitliche Auflösung) des Pulsgenerators und $r$ ein nicht-ganzzahliger Wert ist. Hierzu wird eine Folge von Pulsen mit unterschiedlichen Längen $t(1) \cdot T$, t(2)·T, ... $t(k) \cdot T$ erzeugt. Die Werte $t(1)$ bis $t(k)$ sind dabei so gewählt, dass ihr Mittelwert im wesentlichen gleich r ist. Im Gegensatz zu konventionellen Systemen kann also eine Pulslänge $r \cdot T$ mit $r \neq 0$, 1, ... $n$-1 vorgegeben werden. Somit kann bei gegebener Granularität des Pulsgenerators eine feinere Auflösung erzielt werden.

Vorzugsweise besitzen alle Pulse Längen $R \cdot T$ oder $(R$+1$) \cdot T$, wobei R die nächst tiefere Ganzzahl kleiner oder gleich $r$ bezeichnet. Dadurch werden die Schwankungen der Längen minimal, wodurch die Amplitude der Subharmonischen reduziert wird.

Eine weitere Verbesserung ergibt sich, indem innerhalb einer Pulsfolge die Pulse der Länge $R \cdot T$ und der Länge $(R$+1$) \cdot T$ möglichst gleichmässig verteilt werden. Dies erlaubt es, die Frequenzen der Subharmonischen möglichst hoch zu halten.

Es ist auch möglich, die Werte $t(i)$ der Pulse mit einem Zufallsgenerator zu bestimmen, sofern der Zufallsgenerator so eingestellt ist, dass für grosse Gruppen von Werten $t(i)$ deren Mittelwert wiederum gegen $r$ geht. In diesem Falle kann eine theoretisch unendlich hohe Auflösung erzielt werden.

Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:

Fig. 1 eine Vorrichtung zur Pulsbreitenmodulation mit nachgeschaltetem Tiefpass,
Fig. 2 eine konventionelle Folge von Pulsen und
Fig. 3 eine Folge von Pulsen mit unterschiedlicher Pulslänge.

Wege zur Ausführung der Erfindung

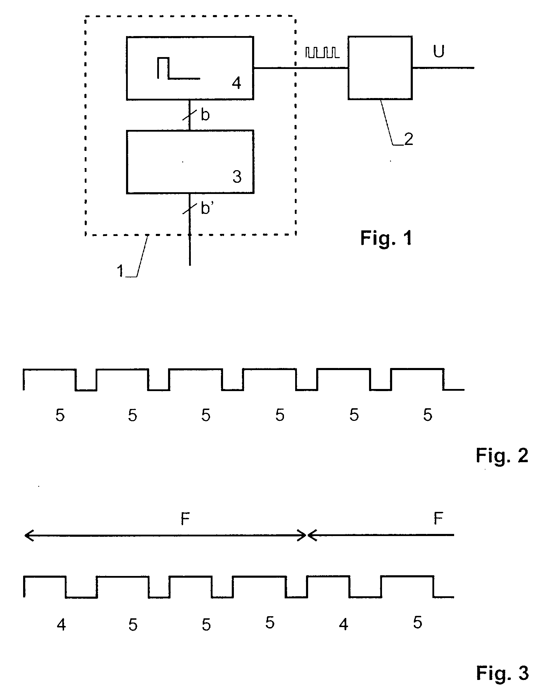

Fig. 1 zeigt eine Vorrichtung 1 zur Pulsbreitenmodulation mit nachgeschaltetem Tiefpass 2. Die Vorrichtung 1 umfasst eine Steuerung 3 und einen Pulsgenerator 4 und sie erzeugt eine Folge von Pulsen mit Spannungsamplitude $U1$. Der Tiefpass 2 ist so ausgestaltet, dass er den Spannungsmittelwert $U$ der Pulse erzeugt.

Bevor auf die erfindungsgemässe Ausgestaltung der Vorrichtung 1 eingegangen wird, soll zuerst die konventionelle Pulsbreitenmodulation kurz erläutert werden.

Normalerweise wird mit dem Pulsgenerator eine Folge von identischen Pulsen erzeugt, wie in Fig. 2 dargestellt. Hierzu wird dem Pulsgenerator vorgegeben, wie lange die Pulse sein sollen, wobei die Wiederhohlfrequenz der Pulse konstant ist. Ein Pulsgenerator mit einem Steuereingang von b Bit kann normalerweise Pulse der Länge $0 \cdot T$, $1 \cdot T$, ... $(n - 1) \cdot T$ erzeugen, wobei $T$ der Granularität bzw. Auflösung des Pulsgenerators entspricht und $n = 2^b$.

Mit einem Pulsgenerator dieser Art lassen sich also insgesamt $n$ unterschiedliche Spannungen $U$ am Ausgang des Tiefpasses 2 einstellen.

Ein Beispiel hierzu ist in Fig. 2 dargestellt. Hier ist z.B. $b = 3$ und $n = 8$ und es werden Pulse der Länge $5 \cdot T$ erzeugt. Besitzen die Pulse eine Amplitude $U1$, so beträgt die Ausgangsspannung $U$ nach dem Tiefpass 2 also $U1 \cdot 5/7$. Die nächst tiefere Spannung, die in konventioneller Weise erreicht werden kann, ist $U1 \cdot 4/7$, die Spannungsauflösung beträgt somit $U1/7$.

Die in Fig. 1 dargestellte Ausführung der Erfindung besitzt einen Steuereingang für die gewünschte Pulsbreite, der eine binäre Breite von $b'$ Bit aufweist, wobei $b' > b$.

Der am Steuereingang anliegende Wert r wird im vorliegenden Beispiel als Zahl in Einheiten von $1/2^{b'-b}$ interpretiert, d.h. mittels $r$ lässt sich die gewünschte Pulslänge $r \cdot T$ zwischen 0 und $(n - 1) \cdot T$ mit einer Auflösung $T/2^{b'-b}$ angeben.

Die Steuerung 3 ist so ausgestaltet, dass sie für eine gewünschte Pulslänge $r \cdot T$ mit dem Pulsgenerator 4 eine Folge $F$ von $k$ Pulsen $P_{t(1)}$, $P_{t(2)}$, .. $P_{t(k)}$ mit mindestens teilweise unterschiedlichen Längen $t(1) \cdot T$, $t(2) \cdot T$, ... $t(k) \cdot T$ erzeugt, wobei $t(i)$ ganze Zahlen sind, und wobei $k = 2^{b'-b}$. Die Werte $t(i)$ sind so gewählt, dass $r$ im wesentlichen dem Mittelwert der Pulse einer Pulsfolge entspricht, d.h.

$$ r \cong \frac{1}{k} \sum_{i=1}^{k} t(i) . \qquad (1) $$

"Im wesentlichen gleich" ist in diesem Fall so zu verstehen, dass die Abweichung des Mittelwerts von $r$ kleiner als $1/k$ ist.

Fig. 3 zeigt eine konkrete Anwendung dieses Verfahrens. Dabei beträgt $b = 3$, $b' = 5$, $k = 4$ und $r = 4.75$. Die Pulse können also Längen 0, $T$, $2T$ bis $7T$ besitzen und jede Pulsfolge $F$ umfasst $k = 4$ Pulse.

Bei einem vorgegebenen Wert r werden in dieser Ausführung zunächst die Werte $R$ und $S = R + 1$ bestimmt, wobei $R$ der nächst tieferen Ganzzahl kleiner oder gleich $r$ entspricht. Sodann werden pro Pulsfolge $F$ insgesamt $k1$ Pulse der Länge $R \cdot T$ und $k2 = k - k1$ Pulse der Länge $S \cdot T$ erzeugt, wobei aus (1) folgt

$$ \frac{k - k1}{K} = r - R. \qquad (2) $$

Für das Beispiel $r = 4.75$ ergibt sich bei $k = 4$ aus (2) die Lösung $k1 = 1$, d.h. innerhalb einer Folge $F$ von vier Pulsen müssen einer die Länge 4 und drei die Länge 5 besitzen. Dies ist in Fig. 3 dargestellt, wo die Pulsfolgen jeweils von der Art RSSS sind, d.h. $t(1) = 4$ und $t(2) = t(3) = t(4) = 5$.

Ist $k1$ bestimmt, so kann die Pulsverteilung innerhalb der Pulsfolgen an sich frei gewählt werden.

Die primitivste Pulsverteilung wäre, dass in jeder Pulsfolge $F$ zuerst alle Pulse der einen Länge und sodann alle Pulse der anderen Länge ausgegeben werden, z.B. für $k = 8$ und $k1 = 3$: RRRSSSSS. Dies ergibt wohl den gewünschten Mittelwert, aber die entstehenden tiefsten subharmonischen Störsignale im Spannungswert $U$ (bei Frequenz $1/(knT)$) haben im Vergleich zum weiter unten beschriebenen verbesserten Verfahren eine relativ hohe Amplitude. Allerdings ist zu bemerken, dass die Amplitude der Subharmonischen im Vergleich zur Amplitude der Harmonischen (bei der Frequenz $1/nT$) einiges tiefer ist, da sie in gewissen Sinn aus einem Wechsel zwischen Spannungen der Grössen $(R/(n-1)) \cdot U1$ und $((R+1)/(n-1)) \cdot U1$ entsteht.

Werden die unterschiedlichen Pulse innerhalb der Pulsfolge $F$ besser verteilt, so können die Amplituden der tiefsten Subharmonischen reduziert werden. Vorzugsweise werden die Pulse der Längen $R \cdot T$ und $(R+1) \cdot T$ möglichst gleichmässig verteilt. Eine "möglichst gleichmässige" Verteilung wird bei einer Pulsfolge erreicht, bei deren wiederholter Aussendung die maximale Zahl aufeinander folgender Pulse gleicher Länge möglichst gering ist. Für $k = 8$ und $k1 = 3$ heisst dies z.B., dass eine Pulsfolge der Art RSRSSRSS gewählt wird (oder z.B. RSSRSSRS, wobei jedoch RSRSSSRSS und RSSRSSRS bei wiederholter Aussendung zu gleichen und lediglich zeitversetzten Pulszügen führen).

Um die Energie auf möglichst viele Subharmonische zu verteilen, kann anstelle einer festen Verteilung der Pulse eine variable Verteilung gewählt werden. In obigem Beispiel können z.B. für $k1 = 3$ nacheinander unterschiedliche

Pulsfolgen ausgegeben werden, z.B. RSRSSRSS, RSRSSRSS, SSRSRSRS, usw. In diesem Falle sind also die Pulsverteilungen aufeinander folgender Pulsfolgen unterschiedlich.

In den obigen Beispielen wird dank dem erfindungsgemässen Verfahren eine Erhöhung der Auflösung um $\log(k)/\log(2)$ Bit erzielt.

Ebenfalls denkbar ist es, die Wahl der Pulsabfolge einem Zufallsgenerator zu überlassen, der so eingestellt ist, dass die Pulslängen für grosse $k$ die Bedingung (1) erfüllen. Hierbei kann auf die Zusammenfassung der Pulse in endlich lange Pulsfolgen $F$ verzichtet werden, und es ist möglich, eine an sich beliebig hohe Auflösung zu erzielen.

In den obigen Beispielen wurden für einen Wert r jeweils Pulse zweier unterschiedlicher Längen $R \cdot T$ bzw. $S \cdot T$ erzeugt. Theoretisch ist es jedoch auch denkbar, mehr als zwei verschiedene Pulstypen zu erzeugen, z.B. eine Folge mit $t(i)$ = 4, 5, 6, 5, 5, 5, 6, 5 für einen Wert von $r$ = 5.125, solange die Bedingung (1) erfüllt wird.

Die hier beschriebene Erfindung kann z.B. in D/A-Wandlern, Netzteilen, Ansteuerungen für Motoren etc. verwendet werden. Sie erlaubt es, den Tiefpass klein zu halten, da die Grundfrequenz $1/nT$ relativ hoch sein kann, ohne dass hohe Anforderungen an die Granularität des Pulsgenerators gestellt werden. Ausserdem kann durch geeignete Wahl der Verteilung der Pulse bzw. der Eigenschaften des Zufallsgenerators das Spektrum der subharmonischen Störsignale einem gewünschten Verlauf angepasst werden, beispielsweise indem der grösste Anteil des Störspektrums im höheren Bereich der Subharmonischen erzeugt wird.

Bezugszeichenliste

| | |
|---|---|
| 1: | Vorrichtung zur Pulsbreitenmodulation |
| 2: | Tiefpassfilter |
| 3: | Steuerung |
| 4: | Pulsgenerator |
| $F$: | Pulsfolge |
| $k$: | Länge der Pulsfolge |
| $k$1: | Zahl der Pulse mit Länge $RT$ innerhalb einer Pulsfolge |
| $k$2: | Zahl der Pulse mit Länge $ST$ innerhalb einer Pulsfolge |
| $n$: | Zahl der vom Pulsgenerator erzeugbaren Pulse |
| $r$: | gewünschte Pulslänge in Einheiten von $T$ |
| $R$: | Ganzzahl unterhalb $r$ |
| $S$: | Ganzzahl oberhalb $r$ |
| $t$: | Pulslänge in Einheiten von $t$ |
| T: | Granularität |

**Patentansprüche**

1. Verfahren zur Pulsbreitenmodulation mit einem Pulsgenerator, der zur Erzeugung von Pulsen $P_t$ einer Länge $t \cdot T$ mit $t$ = 0, 1, ... $n$-1 ausgestaltet ist, wobei T eine zeitliche Granularität des Pulsgenerators ist, **dadurch gekennzeichnet, dass** eine gewünschte Pulslänge $r \cdot T$ mit $0 \leq r \leq n$ - 1 und $r \neq 0$, 1, ... $n$-1 vorgegeben wird, und dass eine Folge $F$ von Pulsen $P_{t(1)}$, $P_{t(2)}$, .. $P_{t(k)}$ mit mindestens teilweise unterschiedlichen Längen $t(1) \cdot T$, $t(2) \cdot T$, ... $t(k) \cdot T$ erzeugt wird, derart, dass der Mittelwert

$$\frac{1}{k} \sum_{i=1}^{k} t(i)$$

im wesentlichen gleich $r$ ist.

2. Verfahren nach Anspruch 1, **dadurch gekennzeichnet, dass** für alle $i$ der Wert von $t(i)$ gleich $R$ oder gleich $S$ = $R$ + 1 ist, wobei $R$ die nächst tiefere Ganzzahl unterhalb $r$ bezeichnet.

3. Verfahren nach Anspruch 2, **dadurch gekennzeichnet, dass** innerhalb der Folge $F$ Pulse der Länge $R \cdot T$ und Pulse der Länge $S \cdot T$ möglichst gleichmässig verteilt werden.

**4.** Verfahren nach einem der Ansprüche 1 oder 2, dass die Werte $t(i)$ von einem Zufallsgenerator erzeugt werden.

**5.** Verfahren nach einem der vorangehenden Ansprüche, **dadurch gekennzeichnet, dass** aufeinander folgende Folgen $F$ von Pulsen unterschiedliche Pulsverteilung aufweisen.

**6.** Vorrichtung zur Pulsbreitenmodulation, **gekennzeichnet durch** Mittel zur Ausführung des Verfahrens nach einem der vorangehenden Ansprüche.

**7.** Vorrichtung nach Anspruch 6 **gekennzeichnet durch** einen Pulsgenerator (4) zum Erzeugen von Pulsen $P_t$ einer Länge $t \cdot T$ mit $t = 0, 1, ... 2^b - 1$ und eine Steuerung (3) zum Empfang einer gewünschten Pulslänge $rT$ und zum Erzeugen von Steuersignalen für den Pulsgenerator (4), wobei $r$ eine binäre Breite von $b'$ Bit besitzt und ein Vielfaches von $1/2^{b'-b}$ darstellt, und wobei $b$ und $b'$ ganze Zahlen mit $b' > b$ sind.

**Fig. 1**

**Fig. 2**

**Fig. 3**

**Europäisches Patentamt**

## EUROPÄISCHER RECHERCHENBERICHT

Nummer der Anmeldung

EP 00 81 0643

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 589 805 A (ZURASKI JEFFERY A ET AL) 31. Dezember 1996 (1996-12-31) * das ganze Dokument * | 1,2,6 | H03K7/08 |
| A | | 3-5,7 | |
| A | EP 0 892 498 A (PEUGEOT ;CITROEN SA (FR)) 20. Januar 1999 (1999-01-20) * Zusammenfassung * * Spalte 4, Zeile 2 - Zeile 12 * | 1-7 | |
| A | GB 2 326 036 A (MOTOROLA LTD) 9. Dezember 1998 (1998-12-09) * das ganze Dokument * | 1-7 | |
| A | EP 0 393 650 A (VICKERS INC) 24. Oktober 1990 (1990-10-24) * das ganze Dokument * | 1-7 | |
| A | US 5 506 545 A (ANDREA RALPH W) 9. April 1996 (1996-04-09) * das ganze Dokument * | 1 | |

RECHERCHIERTE SACHGEBIETE (Int.Cl.7)

H03K
H04B
H02M
H03M

Der vorliegende Recherchenbericht wurde für alle Patentansprüche erstellt

| Recherchenort | Abschlußdatum der Recherche | Prüfer |
|---|---|---|
| DEN HAAG | 4. Januar 2001 | Jepsen, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**                    EP 00 81 0643

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-01-2001

| Im Recherchenbericht angeführtes Patentdokument | Datum der Veröffentlichung | Mitglied(er) der Patentfamilie | Datum der Veröffentlichung |
|---|---|---|---|
| US 5589805 A | 31-12-1996 | EP 0772285 A | 07-05-1997 |
| EP 0892498 A | 20-01-1999 | FR 2766308 A | 22-01-1999 |
| GB 2326036 A | 09-12-1998 | KEINE | |
| EP 0393650 A | 24-10-1990 | US 5023535 A<br>CN 1047135 A,B<br>JP 3000302 A | 11-06-1991<br>21-11-1990<br>07-01-1991 |
| US 5506545 A | 09-04-1996 | KEINE | |

EPO FORM P0461

Für nähere Einzelheiten zu diesem Anhang : siehe Amtsblatt des Europäischen Patentamts, Nr.12/82